# EUROPEAN PATENT SPECIFICATION

(11) **EP 0 715 342 B1**
(45) Date of publication and mention of the grant of the patent: **28.08.2002**
(21) Application number: 95118865.5
(22) Date of filing: 30.11.1995
(51) Int. Cl.: H01L 21/00, C23C 16/46, F27B 17/00, C03B 19/04, C03B 19/06, C03B 19/09

(54) **Single-wafer heat-treatment apparatus and method of manufacturing reactor vessel used for same**
Vorrichtung zur Wärmebehandlung von einzelnen Wafern und Verfahren zur Herstellung eines Reaktorgefässes dafür
Appareil pour le traitement thermique de tranches individuelles et méthode de fabrication de l'enceinte de reaction utilisée pour le traitement

(30) Priority: 30.11.1994 JP 32140694
(43) Date of publication of application: 05.06.1996
(73) Proprietor: Heraeus Quarzglas GmbH & Co. KG, 63450 Hanau (DE); SHIN-ETSU QUARTZ PRODUCTS CO., LTD., Shinjuku-ku, Tokyo 160-0023 (JP)
(72) Inventor: Aoyama, Masaaki, Takefu-shi, Fukui (JP); Miyazawa, Hiroyuki, Takefu-shi, Fukui (JP)
(74) Representative: Kühn, Hans-Christian

(56) References cited:
- WO-A-94/17353
- DE-C- 543 957
- US-A- 4 911 896
- US-A- 4 926 793
- US-A- 5 306 388
- PATENT ABSTRACTS OF JAPAN vol. 007, no. 267 (E-213), 29 November 1983 & JP-A-58 148427 (TOSHIBA CERAMICS KK), 3 September 1983,
- DATABASE WPI Section Ch, Week 8418 Derwent Publications Ltd., London, GB; Class L03, AN 84-110288 XP002007643 & JP-A-59 050 096 (TOSHIBA CERAMICS KK) , 22 March 1984
- DATABASE WPI Section Ch, Week 9306 Derwent Publications Ltd., London, GB; Class L03, AN 93-049500 XP002006888 & JP-A-05 000 900 (TOSHIBA CERAMICS CO) , 8 January 1993
- DATABASE WPI Section Ch, Week 9014 Derwent Publications Ltd., London, GB; Class J04, AN 90-104013 XP002007533 & JP-A-02 055 285 (NIPPON KOJUNDO SEKI) , 23 February 1990

## Description

### Industrial Field of Application

The present invention relates to a single-wafer heat-treatment apparatus, especially to a so-called single-wafer heat-treatment apparatus, comprising a dome-shaped reactor vessel having a ceiling portion and a side portion, and heater or heaters installed outside the reactor vessel, whereby a single wafer can be disposed in the internal space of the vessel for heat-treatment by means of heat from the heater or heaters, whereby at least a heated region of the reactor vessel is manufactured as substantially a single quartz glass body with no welded portion, and at least a part of the heated region is translucent or opaque by bubbles distributed almost throughout the bulk region. The wafer processing may be an under-vacuum film-formation on a wafer, diffusion in a wafer, or chemical treatment such as CVD treatment of a wafer.

### Prior Art

Up to now, under-vacuum film-formation on a wafer, diffusion in a wafer, or chemical treatment such as CVD treatment of a wafer has been conducted in a so-called batchwise treatment mode with a plurality of wafers which are held in a stacking manner in a boat and transferred into a reactor vessel together with the boat for a following predetermined heat-treatment.

In such a treatment mode, turbulence of a gas stream produced in the neighborhood of a contacting spot between a wafer and the boat and turbulence of a gas stream flowing in a space between adjacent wafers stacked one above another both disturb a uniform treatment all over the wafers in a batch of processing.

In the recent trend of increase in the diameter of a wafer which has been changing from 6 inches to 8 inches and further upto 12 inches, there arise difficulty manufacturing a boat and supporting details thereof compatible with increase in weight of a wafer, as far as processing is conducted in the above-mentioned batchwise treatment mode and also take place, in addition, enlargement of a reactor vessel corresponding to the increase in the diameter, and thereby lack of uniformity of both temperature distribution in heating and of gas dispersion, which is further accompanied with meaningless increase in a power for heating.

In a process of fabrication of a semiconductor device with a higher packing density such as 64 M IC of the next generation, processing accuracy within a sub-micron scale is required. There is, however, unavoidable difficulty in attaining such a higher accuracy as required for a wafer in a fabrication process of the device of the next generation in such a conventional batchwise processing mode as mentioned above, since the upper side and lower side of a wafer stacked in a boat is not uniform of treatment conditions and it is also the case between both sides of gas flowing-in and gas exhaust, mutual influences are exerted upon each other between adjacent wafers, and further particles are produced at a contacting spot between a wafer and the boat.

In order to eliminate such faults and to cope with the recent trends toward a larger diameter of a wafer, and a higher packed density and higher quality of a semiconductor device in the next generation, single-wafer heat-treatment apparatuses are drawing attention to the same in which heat-treatment is conducted on a single wafer in each processing.

The single-wafer heat-treatment apparatuses are divided into the two categories, one of which is to install a heater or heaters within a reactor vessel and the other is to position the heater or heaters outside the reactor vessel.

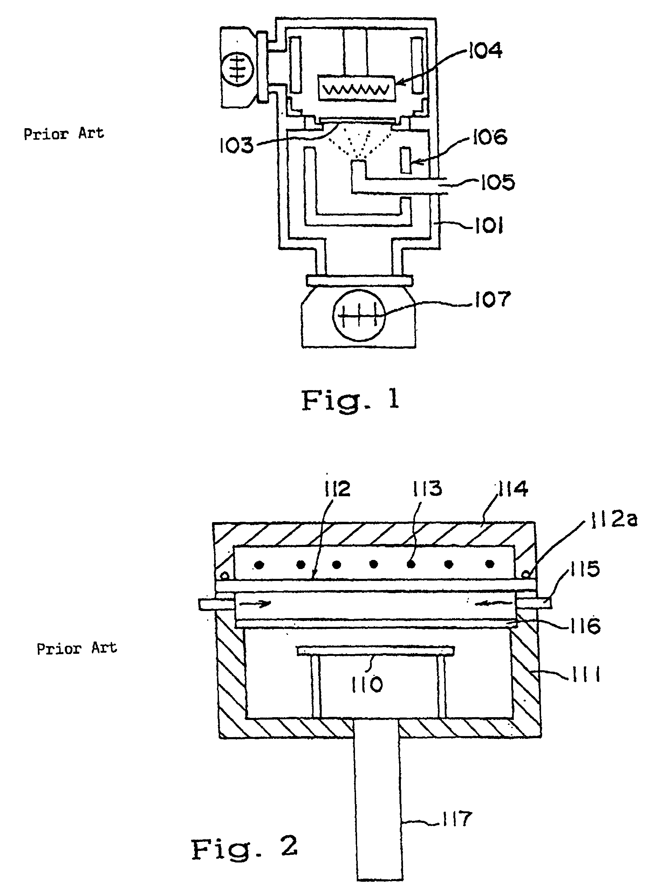

FIG. 1 shows an example of the apparatus which has a heater in the inside of itself, which is disclosed in a book titled "Super LSI Fabrication Testing Apparatus Guide Book" published by Kogyo Chosakai, in Table 5 of page 58. The apparatus of the example comprises a stainless chamber 101 as a reactor vessel, a wafer 103 disposed in the spatial center thereof by means of a susceptor 102, a heater 104 above the wafer 103, a gas nozzle 105 under the wafer 103, a water-cooled shroud 106 surrounding the nozzle 105, and a vacuum pump 107.

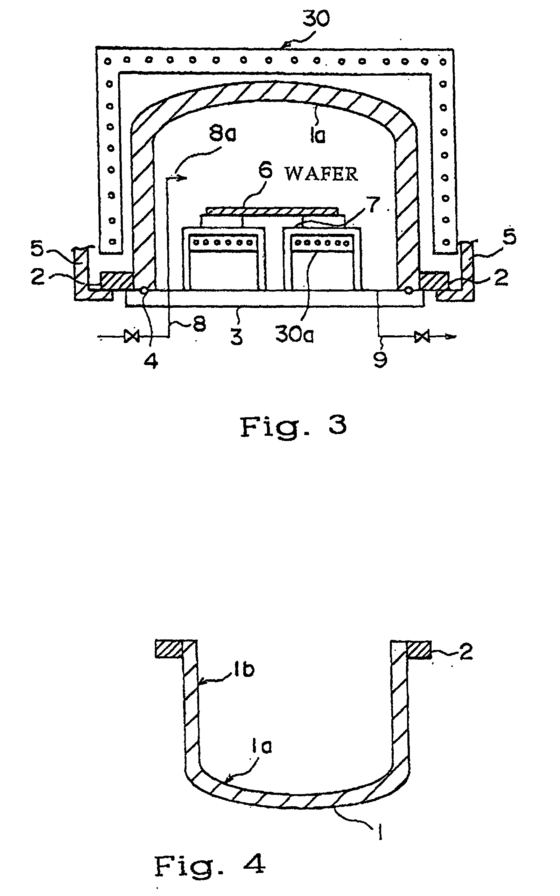

On the other hand, as an external-heater type apparatus, some are disclosed in Table 3 of page 56 of the afore-mentioned Guide Book. One of the apparatus is specialized in heating a wafer from thereabove, as disclosed in Fig. 2 thereof. The apparatus has such a configuration that a quartz glass window 112 is attached in a sealing condition to an upper opening of a stainless vessel 111 which accommodates a wafer 110 in itself, heater lamps 113 and a housing therefor 114 are installed above the quartz glass window 112, the wafer 110 is heated through the quartz glass window 112, where in FIG. 2 115 indicates a gas inlet, 115 a gas distributor plate, and 117 a channel for an exhaust gas in communication with a vacuum pump.

A heat-treatment apparatus for singe-wafers is known from US-A- 4,926,793. This extemal-heater type apparatus has a reactor with a double casing. The outer casing is a dome member made of tranparent quartz glass material having high transparency of infrared rays. However the outer casing is not limited to tranparent quartz glass but can also be made of opaque quartz glass with bubbles inside. The inner casing is also made of quartz glass and has a dome shape similar to the outer casing but smaller than that The outer and inner casing are sealed on a base plate. A gas may be supplied to the reactin chamber biult inside the inner casing. The disclosed apparatus shows a complex construction but does not focus on improved heating performance.

### Problem the Invention Seeks to Solve

In the former internal-heater type apparatus, however, there is installed as a heat shield the water-cooled shroud between the vessel and a heated region and from that condition a problem is easier to arise in regard to uniform distribution of heating.

On the other hand, even in the latter external-heater type apparatus, in order to prevent an O-ring, lying between the quartz glass window 112 and a sealing portion 112a at the upper end of the stainless vessel 111, from heat deterioration, the portion in the vicinity of the sealing portion 112a is required to be water-cooled, and the afore-mentioned faults are, therefore, not eliminated in a aspect of uniform distribution of heating or in another aspect of complication of structure.

In either technique, complication of the structures cannot be unavoidable due to necessary water-cooling of a greater part of the apparatuses, a problem arises in holding a degree of air-tightness, since the junction between the heat-transparent material and the water-cooled material is unavoidably positioned close to the heat-receiving portion, and besides another problem is brought about in relation to adopting the stainless vessel as a reactor vessel.

In light of the above-mentioned circumstances, a study is conducted about a vessel all composed of transparent quartz glass similar to a conventional furnace tube as an alternative of the above-mentioned reactors. For example, a reactor vessel is proposed which comprises an end cover and a lower vessel in Table 3 of page 56 of the afore-mentioned Guide Book, which also has a problem that an O ring at a sealing portion is subject to deterioration, since the

O-ring is required for sealing when the vessel is thus divided into two parts. Therefore, a single-wafer heat-treatment apparatus , too, is studied that has shapes of approximation of a dome or a cylinder at an end of which an end cover such as shaped as a flat plate or a hemisphere is welded, similarly to the shape of a conventional vertical furnace tube.

In the past, a wafer was generally smaller in diameter at 6 inches and a reactor tube was able to be manufactured by a welding technique, but in the recent treatment process for a semiconductor wafer, enlargement of a wafer in diameter has been much advanced to 8 inches or 12 inches and in company with this trend a reactor vessel has also been enlarged. Thus it has become hard in an aspect of mechanical strength thereof as well as another aspect of processability in manufacture by a welding technique only of such a larger reactor vessel.

What's more, a quartz glass reactor vessel is manufactured with transparency in order to be able to receive heat from the outside and to manufacture it all with such transparency requires to heat a wider portion in the reactor vessel beyond a necessity for heating a wafer. As a result, unnecessary reactions in the vessel or unfavorable influences on facilities in the neighborhood around the vessel take place.

Being transparent of quartz glass as a structure material means the good heat conduction and therefore the location of a flange comprising a sealing portion have to be considerably remote from a heating region, so that the reactor vessel unavoidably becomes lager in diameter and thus also larger in height in order to have the sealing portion retreat enough from the heated region.

It is an object of the present invention to provide a heat-treatment apparatus which secures enough mechanical strength of its own and preferable uniform heating effect on a wafer even when the diameter thereof is enlarged to 8 inches and to 12 inches, in other words, when the reactor vessel is enlarged to accommodate the such an enlarged wafer.

It is another object of the present invention to provide a heat-treatment apparatus that secures both a heat insulation effect and uniform heating effect of a heated region of a wafer, prevents an portion of the vessel for which it is unnecessary to be heated from being heated, and further effectively stops not only unnecessary reactions, but also both a sealing portion and neighboring facilities being unfavorably affected.

It is a further object of the present invention to provide a heat-treatment apparatus with which improvement on working efficiency in load and unload of wafers and facilitation of related operations are achieved.

### Means to Solve the Problem

What is featured by the present invention is that the heat receiving ceiling portion of the reactor vessel is composed of substantially transparent quartz glass and almost all side portion at the lower end of the vessel is composed of translucent or opaque quartz glass with inclusions of bubbles therein.

The reactor vessel is generally shaped as a dome, or a cylinder and preferably it all is composed as a single body except a flange portion.

It is necessary that the circular opening of the lower end of the rector vessel later joins a flange by welding along the outer periphery and another member later joins by fusion a region which is not heated, though the lower end opening of the reactor vessel may be left as it was. It is required, therefore, in order to exert a function as described later that at least the heated region of the vessel is composed substantially as a single body with no welded portion therein.

A transparent window for grasping a state of heat-treatment of a wafer may be arranged in a position where the window does not affect heat-treatment of a wafer in the heated region of the vessel at any rate.

The definition of being translucent or being opaque should preferably be made based on heat ray, for example transmittance of light at a wavelength of 2 µm, because the present invention intends improvement on uniformity of heating and to achieve it, heat ray is required to radiate through the ceiling portion to the surface of a wafer. A degree of being translucent or opaque is preferably set in the range of 30 % to 1 % in transmittance of light at a wavelength of 2 µm in order to exert a function as described later.

In order to achieve a state of being translucent or opaque in a simple way, it is apparently possible to make only either the outer surface or inner surface translucent or opaque by application of sandblasting. This processing only gives micro-irregularity only on the surface, inner or outer, and this superficial phenomenon is not effective, allows heat conduction through the thickness to the lower end opening side, and as a result, a function of the present invention is not exerted in a smooth manner.

Therefore, in order to maintain effects of uniform heating and heat insulation over a long time of operation, as is achieved by the present invention, bubbles are preferably included in the bulk of the wall to thereby prevent heat conduction through the thickness. On this occasion, the density of bubbles in the bulk of a heated region is in a stable manner preferably adjusted in the range of 20,000 bubbles/cm³ to 100,000 bubbles/cm³ with diameters of the included bubbles being in the range of 10 µm to 250 µm.

In an internal-heater type apparatus, however, a reactor vessel is forced to be constructed in a larger scale, since the heater is contained in the vessel. A water-cooled shroud is installed as a heat shield between the vessel and a heating region and thereby a problem is apt to arise in an aspect of uniformity of heating. Another problem is, what's more, present that pollutants from the heater is easy to attach on a wafer and thereby the surface of the wafer is polluted, since the heater is directly configured face to face with the wafer.

On the other hand, in the latter external-heater type apparatus as shown in FIG. 2, in order to prevent an O-ring lying between the quartz glass window portion 112 and a sealing portion 112a at the upper end of the stainless vessel 111 from heat deterioration, the portion in the vicinity of the sealing portion 112a is required to be water-cooled, and the afore-mentioned faults are, therefore, not eliminated in a aspect of uniform distribution of heating or in another aspect of complication of structure.

Therfore in the present invention, in which a heater or heaters are installed above the reactor vessel in the region of the ceiling portion, the ceiling portion is composed of substantially transparent quartz glass and almost all the side portion of the vessel covering from the heat-receiving portion to a sealing portion at the lower end of the vessel is composed of translucent or opaque quartz glass with inclusion of bubbles therein.

Also in this embodiment, all of the vessel is preferably constructed as a single body with exclusion of a flange portion. It is necessary that the circular opening of the lower end of the rector vessel later joins a flange by welding along the outer periphery and another member later joins by fusion a region which is not heated, though the lower end opening of the reactor vessel may be left as it was. It is, therefore, necessary that at least the heated area of the side portion of the vessel neighboring the ceiling portion as well as the ceiling portion itself is preferably composed as substantially a single body with no welded portion therein from a view point of exertion of the function of the present invention later described.

The definition of being translucent or being opaque should preferably be made based on heat ray, for example transmittance of light at a wavelength of 2 µm, because in the present invention heat ray is required to radiate through the ceiling portion to the surface of a wafer.

In order to properly exert the later-described function, it is preferable that the ceiling portion of the vessel is transparent at a transmittance of 85 % or more at a wavelength of light of 2 µm and the side portion of the vessel left by exclusion of the heated area neighboring the ceiling portion thereof, where the left side portion is downward of the ceiling, is composed of a quartz glass having a transmittance of 30 % or less at a wavelength of 2 µm of light.

If there exist a clear boundary like that caused by welding between the ceiling portion of the vessel and the side portion, a risk may arise that the boundary portion is locally heated or heat ray is scattered or reflected there in a poor uniformity and as a result a heated object is heated in a poor uniformity. According to the present invention, no clear boundary of inclusion of bubbles is present between the ceiling portion of the vessel, the side portion thereof and the interface therebetween is composed in such a manner that densities of bubbles are gradually changeable and the gradual change in bubble density preferably occurs substantially in the heated area surrounding the ceiling portion of the vessel.

Even in the side portion of the vessel where a density of bubbles is measured in a stable manner across, there is a chance locally to locate a transparent portion such as a window. On this occasion, the window portion is used for observation of a treatment state of a wafer, and the observation window portion and the surrounding area, which is translucent or opaque, of part of the side portion of the vessel is preferably composed as substantially a single body with no welded portion therein.

The position where the wafer is located is preferably in the internal space of the vessel corresponding to the portion thereof, translucent or opaque, of the downward side of the transparent portion of the ceiling portion.

The embodiment of the invention secures both a heat insulation effect and uniform heating effect in a wafer heating region, prevents a portion of the vessel for which it is unnecessary to be heated from being heated, and further effectively stops not only unnecessary reactions, but also both a sealing portion and neighboring parts from being unfavorably affected.

Since transmission of heat ray is in a lower level in the side portion of the vessel which is translucent or opaque, In other words, since a temperature in the area in the vicinity of the lower-end opening does not rises to a undesirable level, an O-ring is used for sealing by a flange even with no special precaution.

The reactor vessel is placed on a support table above which a wafer is disposed in a predetermined position with a sealing portion lying therebetween and the reactor vessel is preferably separable from the support table relatively in a direction of moving away from each other. A channel for gas feed and an exhaust port are both preferably located on the side of the support table only, but not on the side of the vessel.

Since a reactor vessel and a support table above which a wafer is disposed in a predetermined position are relatively separable from each other in a direction of moving away from each other, loading and unloading of wafers becomes easier. With channels for a fluid attached on the side of the support table only, the reactor vessel and a heater above the vessel combined can be a movable portion, which is shiftable vertically. In other words, simplification of an apparatus comprising the vessel, support table and the like can be realized, because it is not necessary to move the channels for the fluid upward or downward.

### Function

With such a technical means, effects of heat insulation and uniform heating of the heated region for a wafer are much improved, because the region itself is composed of quartz glass material, translucent or opaque, with poor heat conductance, in particular, a quartz glass having bubbles included therein with a light transmittance of 30 % to 1 % at a wavelength of light of 2 µm, where the effect of uniform heating is decreased when a light transmittance is 30 % or more, and the meaninglessly excessive effect of heat insulation is obtained and in addition productivity is poorer when a light transmittance is 1 % or less.

The transmittance of a light of a wavelength of 2 µm is preferably set so as to be different not only between the internal-heater type and the external-heater type, but also in dependence on a temperature of heat-treatment. For example, in the internal-heater type, the transmittance is preferably set in the range of 1 % to 20 % under a stress put on the effect of heat insulation and on the other hand, in the extemal-heater type, the transmittance is preferably set in the range of 5 % to 30 %, more preferably, in the range of 10 % to 30 % due to a necessity of a proper extent of transmittance. As to a bubble density, too, the density in the heated region, where bubbles are distributed in a stable manner of density, is preferably set so as to be different between both types. That is, in the internal-heater type, where the effect of heat insulation is stressed, various bubbles dispersed in the range of 10 µm to 250 µm are preferably included at a density selected from the range of 40,000 bubbles/cm³ to 100,000 bubbles/cm³ and on the other hand, in the external-heater type, at a density selected from the range of 20,000 bubbles/cm³ to 80,000 bubbles/cm³.

Under conditions of inclusion of bubbles at such a higher density and the bulk internally being translucent or opaque, undesirable escape of heat ray into a region in the neighborhood of the heated region where heating is unnecessary is effectively prevented. This effect of prevention of the wrong heating invites increase in effect of uniform heating in the heated region, also realizes thereby a stable level of productivity with a higher quality of a product, and in addition allows the use of an O-ring for sealing without a special precaution, since the temperature at the flange portion attached along the outer periphery of the lower-end opening of the vessel does not go up to a meaninglessly higher level.

In order to attain a state of being translucent or opaque, a sand-blasting treatment may be used, but this treatment is to give a roughening treatment only on the surface of a transparent quartz glass body. Consequently, because an effect obtained by the sand-blasting treatment on a surface is restricted to the surface region with respect to being translucent or opaque, when an etching-treatment or heat-treatment is applied to the surface, the surface region becomes transparent. And what's worse, heat is conductible toward the flange side through the bulk of the wall. As a result, the function targeted by the present invention is not achieved.

According to the present invention, since it is possible that heating is not conducted beyond a necessary region for heating a wafer, undesirable reactions or wrong influences on surrounding facilities do not arise, and heat-conduction outwardly from a heated region is prevented, the heated region and a sealing portion can be close to each other without a water-cooled shroud or water-cooled jacket, so that an apparatus for the use can be constructed in a smaller scale and in a simpler manner.

In a reactor vessel of the present invention, since at least a heated region is composed in a state of not having a welded portion and substantially a single body therein, in other words, since an interface of welding does not exist, cracking or breakage due to thermal residual-strain could be avoided at the interface.

A fact of being composed substantially in a state of a single body means that no local strain or biased loading in the heated region arises. Under conditions of vacuum and heating at about 1000 °C, since the region does not thus loose a mechanical strength thereof locally or partly and by such a increase in the mechanical strength, a higher-speed heating-up and higher-speed cooling-down of a wafer in a wafer-treatment process is made possible, so that the productivity can be improved.

With a vessel according to the present invention, heating of the wafer is carried out without heating a wider portion beyond necessary and thereby not only unwelcome reactions, but also a wrong influence on the surrounding parts do not occur. And the heated area and the sealing portion of the side portion can effectively be shielded by the side portion of the vessel therebetween and thereby the heated area can be located to some extent close to the sealing portion without a water jacket, so that the vessel is constructed in a small scale and a flat form and the apparatus can be simplified. What's more, a reactor vessel according to the present invention, is composed as substantially a single body with no welded portion at least in the ceiling portion and the surrounding heated area, in other words, with no boundary caused by welding therein, and thus cracking or breakage by thermal residual strain can be avoidable therein.The reactor vessel being substantially in a state of a single body means that not only neither occurrence of local strain nor biased load, but also no local or partly decrease in mechanical strength all over the vessel can be assured even under conditions of vacuum and heating at about 1000 °C. Even though being translucent or opaque can be processed by sand blasting on the surface of the side portion of the vessel, the portion after being treated in etching or heat treatments becomes transparent, since the sand blasting treatment gives its influence only on the surface region of the transparent quartz glass by blowing sands against the surface for roughening and heat ray is conductible through the bulk of the wall due to thus being transparent, so that the flange side is affected by heat ray.According to the present invention, being translucent or opaque of the side portion of the vessel is not achieved so as to be superficially so by processing only the surface region, as done by sand blasting, but so as to be.as far as the interior of the bulk by inclusion of bubbles therein and therefore the afore-mentioned faults are all solved. What's more, the vessel according to the present invention has no clear boundary by inclusion of bubbles between the ceiling portion and side portion thereof and to the contrary bubble densities are gradually changed in magnitude across therebetween so as to include no bubble boundary. On this occasion, thermal mechanical-strength is further increased and at the same time gradual descending of temperature along the distance from the ceiling portion of the vessel to the lower-end opening is made possible, so that a heating atmosphere with good balance which makes possible heat-treatment of a wafer with a higher quality is obtainable. Further, according to the present invention, the mechanical strength of the vessel is increased and thereby in a wafer treatment a higher speed heating and a higher speed cooling are made possible, so that productivity is improved.Still further, a transparent window portion located in the side portion of the vessel is composed as substantially a single body with no welded portion and therefore, the thus manufactured vessel is better in regard to the airtightness and the production.Since the location of the wafer is in the internal space corresponding to a portion, translucent or opaque, downward of the transparent portion of the ceiling portion, the location is better not only in regard to observation by naked eyes, but also in regard to heat insulation.What's more, exchange operation of wafers becomes easier, since the reactor vessel and the support table are structured separable in the direction of their moving away from each other. In addition, the pipe for introducing a gas and the exhaust port is not located on the side of the reactor vessel, but these fluid channel is located on the side of the support table, the reactor vessel and the heater portion located thereabove combined can be constructed as a moving part conducting a vertical motion, upward or downward, which means in other words it is not necessary for the fluid channel to shift vertically, and as a result simplification of the apparatus and related facilities is achievable.Further, because of no a metal jacket built-in in the reactor vessel, confirmation by an operator in the inside of the apparatus and at the same time the window portion is constructed in a relation of a single body with the surrounding portion.

What's better, since a material of the reactor vessel is quartz glass itself and a metal jacket is not used, not only a confirmation of the internal state of the vessel, but also a window portion being built-in and the like are easier.

With such a technical means, even in an external-heater type heat-treatment apparatus, effective heating is materialized by receiving heat ray with no loss on a wafer in the vessel, since the ceiling portion positioned on the side of the ceiling and if necessary an observation window portion as well are substantially transparent, in more concrete terms of a transmittance of 85 % or more by heat ray.

Beside, almost all the side portion of the vessel from the ceiling portion to the lower-end opening is composed of a quartz glass with poor heat-ray transmission and poor heat conduction, in particular, of a quartz glass with a heat-ray transmittance of 30 % or less, thereby the wafer-heating region which is positioned in the internal space corresponding to such a side portion is improved on heat insulation thereof, and further thereby a degree of uniformity of heating throughout the vessel is improved by effective prevention of the escape of the wrong heat ray to an area where heating is not necessary, so that production with a stable and higher quality becomes possible.

### Examples

Examples of the present invention are described in detail illustratively in reference to the accompanying drawings below. It is to be expressly understood that the dimensions, materials, shapes and relative configuration of composing parts described in the examples are shown only for the purpose of illustration and not restricted to define the scope of concepts of the present invention, unless specially stated.
- **FIG. 1**: is a schematic view illustrating the internal construction of a conventional single-wafer heat-treatment apparatus.
- **FIG. 2**: is a schematic view illustrating the internal construction of another conventional single-wafer heat-treatment apparatus.
- **FIG. 3**: is a schematic view illustrating the internal construction of an external-heater single-wafer heat-treatment apparatus according to Example of the present invention where a reactor vessel as shown in FIG. 4 is used.
- **FIG. 4**: is a sectional view of a reactor vessel used in an apparatus as shown in FIG. 3.
- **FIG. 5**: is a schematic view illustrating the operational principle of an apparatus for manufacturing a reactor vessel as shown in FIG. 4.
- **FIG. 9**: is a schematic view illustrating the internal construction of an single-wafer heat-treatment apparatus according to an example of the present invention where a reactor vessel as shown in FIG. 11 is used.
- **FIG. 11**: is a sectional view of a reactor vessel used in an apparatus as shown in FIG. 9.
- **FIG. 13**: is a sectional view of a reactor vessel used in an apparatus as shown in FIG.9.

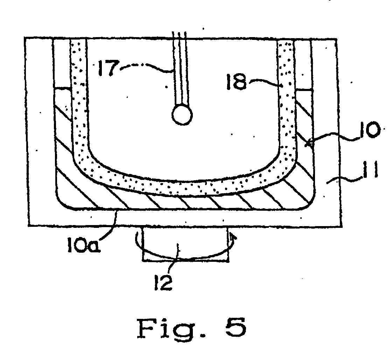

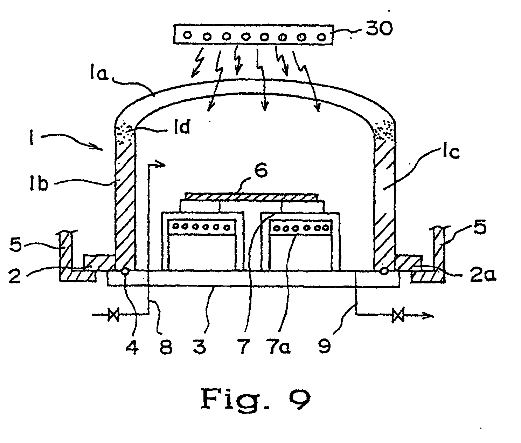

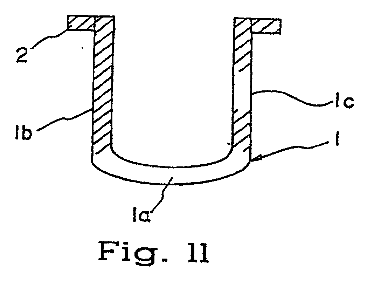

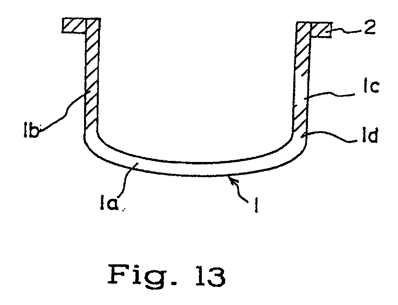

Fig.5 is a view showing in principle an apparatus of manufacturing a reactor vessel which has a shape of a cylinder with a dome at the top, in particular, the apparatus of manufacturing a reactor vessel used for an extrenal-heater type heatreatment apparatus as shown in Fig. 3, wherin the apparatus of manufacturing the reactor vessel comprises a mould 10 which is freely rotatable and can be said rotary vessel, a mould holder 11 which holds the mold in such a manner as to be freely attaches to or detached from the mould 10, means for rotating the mould 10 together with the holder 11 and a heat source 17.

First, the mould 10 gets rotated together with the holder 11 and then crystalline or amorphous quartz powders are fed into the mould 10 to form a quartz powder layer-like body 18 with a thickness of 20 mm along the inner surface of the mould 10 by means of a centrifugal force.

In sequence, a heat source 17 is disposed in a middle position inside the mould 10 and melting by heating is then conducted to manufacture a reactor vessel having a predetermined shape.

The thus manufactured vessel 1 is processed on the outer surface by grinding and polishing, further the side of the end opening is so ground that the end surface is aligned in a plane perpendicular to the axis of the vessel over the periphery, and if necessary, a flange 2 is joined, so that a reactor vessel 1, as shown in FIG.4, can be completed.

FIG. 3 is a view showing a single-wafer CVD apparatus in which a reactor vessel 1 as shown in FIG. 4 is used, where the quartz glass reactor vessel 1 having a shape like a dome is installed on a support table 3. A flange 2 joins the lower-end opening of the reactor vessel 1 along the outer periphery thereof and an O-ring 4 is embedded in the portion of the flange 2 facing the support table 3 to seal air-tight the interface between the reactor vessel 1 and the support table 3.

The flange 2 is laterally outwardly extended beyond the periphery of the support table 3 and the reactor vessel 1 is lifted by being engaged with a lifter 5 at the outwardly extended portion of the flange 2a together with heater-lamps in order that a wafer 6 is exposed to the air outside the reactor vessel 1 and thereby wafers 6 are exchanged with ease.

In the outside region surrounding the reactor vessel, an external-heater 30 is disposed in a surrounding manner and thereby a space in which a wafer is disposed is all heated across.

On the support table 3, a susceptor 7 the material of which is graphite or quartz glass, a gas inlet pipe 8 and an exhaust port 9 are equipped with,

The susceptor 7 includes an internal heater 30a for heating the wafer 6 from the back thereof and thus the wafer 6 is heated not only on the front by the external heater from outside the reactor vessel 1, but also from the back by the internal heater 30a, so that a time required to reach a temperature at which film formation is carried out is shortened due to both sided heating.

Since the internal heater 30a is located under the wafer 6 and enveloped by the susceptor 7, there is no fear that particles from the internal heater 30a pollutes the surface of the wafer 6, even though the internal heater is present in the inside of the reactor vessel.

The gas inlet pipe 8 is configured in such a manner that a nozzle 8a attached at the fore-end is vertically upwardly extended in the space of the reactor vessel 1 and the nozzle 8a postures in a direction at such a slight downward angle that the gas may be distributed all over the wafer 6. An inclination angle of the nozzle 8a is preferably set roughly in the range of 0 degree to 45 degrees, more preferably, in the range of 15 degrees to 30 degrees.

When a CVD film is formed on a wafer 6 by such an apparatus, first, the wafer 6 is heated, in such a state as shown in FIG. 3, to a predetermined temperature by both of the external heater 30 and the internal heater 30a. and then a CVD treatment is conducted while flowing-in a reaction gas from the nozzle 8a of the gas inlet pipe 8 in the vessel 1, so that a reaction for film formation is performed.

After completion of the film formation reaction, the lifter 5 is shifted upward to lift the reactor vessel 1, so that the wafer 6 is exposed to the air outside the vessel 1 and exchangeable with an untreated wafer 6 with ease.

The afore-mentioned operations of the treatment are repeatable with simplicity and ease.

As described above, according to the present invention, a reactor vessel can be enlarged with no welded portion formed therein in correspondence to increase in the diameter of a wafer with ease and beside enough mechanical strength thereof, in particular, enough strength against thermal shock can be achieved. With the use of such a reactor vessel, higher-speed heating-up and higher-speed cooling down is both made possible with no reduction in strength of the vessel against thermal shock, even when the diameter of a wafer processed as in the recent semiconductor fabrication is enlarged to 8 inches or 12 inches, which makes a level of safety and productivity in the related operation increased.

Since a quartz glass reactor vessel has a translucent or opaque portion as a heated region, both degrees of heat insulation and uniformity in heating are improved in the vessel with no heating of an unnecessary portion and heating of a wafer is carried out with no heat conduction upto an unnecessary portion, which as a result makes it possible to perfectly prevent not only an unnecessary reaction, but also unfavorable influence on surrounding facilities and a sealing portion.

In addition, even though the sealing portion is located somewhat close to the heated region of the reactor vessel, heat deterioration of the sealing portion does not arise and as a result a vessel in a smaller size or in a flat shape is realized, which directly entails improvement on heat efficiency and uniformity of heating.

Still in addition, according to the present invention, other advantages can be achieved that improvement on working efficiency in exchange of wafers and facilitation of operation of the apparatus and surrounding facilities thereof are materialized.

In a reactor vessel 1, as shown in FIG. 11, both the ceiling portion 1a and the window portion 201c of which are transparent and the side portion of which is translucent or opaque is finally manufactured.When content of bubbles included in the side portion 1b, which is translucent or opaque, of the reactor vessel 1 is measured, the densities of bubbles having diameters dispersed in the range of 10 µm were 40,000 bubbles/cm³ or more and it was confirmed that no clear boundary was present between the transparent portions, which were the ceiling portion 1a and window portion 1c of the vessel, and the portion, translucent or opaque, which was the side portion 1b. The transmittance of the ceiling portion 1a of the vessel 1 was by far more than. 85 % and more 90 % or more in some measured points and measurements of the side portion, which is translucent or opaque, were on the contrary much lower than 30% and in some points 10 % or less.

A reactor vessel 1 was manufactured and a heated area 1d which was in a half way level in transmittance was formed around the transparent ceiling portion 1a of the vessel 1 as shown in FIG. 13, where gradual change in bubble densities was realized. In the above-mentioned vessel, bubble content in the half level region were 20,000 bubbles/cm³ or more when bubbles having diameters dispersed in the range of 10 µm to 250 µm were counted and the transmittance by heat ray were measured at values of 30 % or less, which satisfied a condition of the present invention. FIG. 9 is a schematic view illustrating the internal construction of a single-wafer CVD apparatus formed by using a reactor vessel 1 shown in FIG. 11, where the above-mentioned reactor vessel 1 having a shape like a cylinder with a dome at the top is placed on a support table 3 composed of quartz glass. A flange 2 joins surrounding the outer periphery of the lower end opening, an O-ring 4 is inserted in the portion of the vessel facing the support table 3 to assure airtight sealing between the reactor vessel 1 and the support table 3.

The flange 2 extends outwardly of the outer periphery of the support table 3, the reactor vessel 1 is lifted together with a heater lamp by a lifter 5 which engages with the over-extending part 202a. By the lifting, a wafer 6 is relieved to the open air outside the reactor vessel 1, which makes it easy to exchange wafers.

On the support table 3, a susceptor 7 composed of graphite or quartz glass which is used for disposing a wafer 6, a pipe for introducing a gas, and an exhaust port 9.

A heat source 7a is contained in the susceptor 7 for heating the wafer 6 from the back The wafer 6 is consequently heated by the heat source 7a on the back side thereof as well as by a lamp 30 installed above the transparent ceiling portion 1a of the vessel 1, so that the wafer 6 is heated up to a temperature of film formation in a shorter time due to both sided heating.

Since the heat source 7a is located under the wafer 6 and beside is contained in the susceptor 7, though the heat source 7a is present in the vessel 1, particles produced from the heat source 7a has no risk to attach on the surface of the wafer 6.

A position in which the wafer 6 is located is in the internal space of the vessel corresponding to a side portion 1b, translucent or opaque, extending downwardly of the ceiling portion 1a of the vessel 1, and thereby effects of heat insulation and uniformity in heating on the wafer heating region are guaranteed. The position of the wafer is also preferably selected so that the height of the wafer 6 is equal to or slightly lower than that of the window portion 1 c and thereby a state of film formation on the wafer 6 is observable through the window portion 1c from outside the vessel 1.

The pipe 8 for introducing a gas is so configured that first it extends vertically to above the wafer 6 and then a nozzle 208a attached at the fore end of the pipe 8 is slightly downwardly directed in order that the gas is distributed all over the wafer 6.

An angle of inclination of the gas nozzle 8a is preferably set in the range of 0 degree to 45 degrees, more preferably in the range of 15 degrees to 30 degrees.

The heating lamp 30 is located above the transparent ceiling portion 1a of the vessel 1.

When a CVD film is formed with such an apparatus, the operation proceeds as follows: First, a wafer 6 is heated from both sides by the heating lamp 30 and the heat source 7a under the situation as shown in FIG. 9 to heat up to a predetermined temperature, second, a reaction gas is fed from the nozzle of the pipe 8 for introducing the gas and the reaction of film formation is carried out, third, after completion of the reaction of film formation, the reactor vessel is lifted by shifting the lifter 5 vertically upwardly, and finally, as a result, the wafer 6 is exposed to the open air outside the vessel 1 and wafers 6 are exchanged with ease, where all the afore-mentioned steps are repeated for following film formation on wafers with ease and simplicity.

In any of the examples above mentioned, the pipes are all attached on the lower surfaces of the support tables 3, in other words, the fluid devices are not mounted on the side of the reactor vessel 2 at all, and the reactor vessels 1 can be shifted upwardly together with the heating lamps 30, so that improvement on working efficiency due to facilitation of not only exchange of wafers, but also maintenance is achievable and simplification of the facilities can be realized as well.

According to the present invention, a reactor vessel can be enlarged with no welded portion formed therein with ease in correspondence to increase in the diameter of a wafer and beside enough mechanical strength thereof, in particular, enough strength against thermal shock can be achieved. With the use of such a reactor vessel, higher-speed heating-up and higher-speed cooling down is both made possible by increase in strength of the vessel, even when the diameter of a wafer processed as in the recent semiconductor fabrication is enlarged to 8 inches or 12 inches, which as a result makes productivity increased.

The heat insulation effect in the vessel is improved owing to no heating a wider portion beyond necessary for heating a wafer and at the same time conduction of heat as far as to an unnecessary portion for heating the wafer is prevented, so that not only undesirable reactions, but wrong influence of heat on the surrounding parts and a sealing portion are also completely prevented.

## Claims

1. A wafer heat-treatment apparatus comprising a dome-shaped reactor vessel having a ceiling portion and a side portion, and heater or heaters installed outside the reactor vessel in the region of the ceiling portion, whereby a single wafer can be disposed in the internal space of the vessel for heat-treatment by means of heat from the heater or heaters, whereby at least a heated region of the reactor vessel is manufactured as substantially a single quartz glass body with no welded portion, and at least a part of the heated region is translucent or opaque by bubbles distributed almost throughout the bulk of the region, **characterized in that** the heat receiving ceiling portion (1a) is composed of substantially transparent quartz glass and almost all the side portion (1b) of the vessel (1) covering from the heat receiving ceiling portion (1a) to a sealing portion at the lower end of the vessel is composed of translucent or opaque quartz glass with inclusion of bubbles therein.

2. A wafer heat-treatment apparatus as claimed in claim 1, **characterized in that**, **characterized in that** a transparent window (1c) is arranged in the side portion (1b) of the vessel (1) that is integral with the other part.

3. A wafer heat-treatment apparatus as claimed in claim 1 or 2, **characterized in that** the reactor vessel (1) is placed on a support table (3) with a sealing portion (4) lying therebetween, and **in that** the reactor vessel (1) is separable from the support table (3) relatively in a direction of moving away from each other, wherein a wafer can be disposed at a predetermined position above the support table (3).

4. A wafer heat-treatment apparatus as claimed in claim 3, **characterized in that** a gas inlet (8) or inlets and a gas outlet (9) or outlets are located only on the side of the support table (3).

5. A wafer heat-treatment apparatus as claimed in one or more of the preceding claims, **characterized in that** a heater (30) or heaters are installed above the reactor vessel (1) in the region of the heat receiving ceiling portion (1a) and that the ceiling portion (1a) of the vessel (1) is constructed as a transparent portion having a transmittance of 85 % or more at a wavelength of light of 2 µm, and almost all the side portion (1b) of the vessel (1) excluding the heated region (1d) neighboring the ceiling portion (1a) which is downward of the heated region (1d) is a translucent or opaque side portion (1b) having a transmittance of 30 % or less at a wavelength of light of 2 µm.

6. A wafer heat-treatment apparatus as claimed in claim 5, **characterized in that** a density of the bubbles in the side portion (1b) of the vessel (1) left by excluding the neighboring area of the ceiling portion (1a) of the vessel is set 20,000 bubbles/cm³ or more, preferably 40,000 bubbles/cm³ or more,when the bubbles of diameters dispersed in the range of 10 µm to 250 µm are counted.

## Patentansprüche

1. Vorrichtung zur Wärmebehandlung von Wafem, umfassend ein kuppelförmiges Reaktorgefäß mit einem Deckenbereich und einem Seitenbereich, und mit außerhalb des Reaktorgefäßes im Deckenbereich installierten Heizer oder Heizern, wobei ein einzelner Wafer zur Wärmebehandlung durch die Hitze des Heizers oder der Heizer im Innenraum des Gefäßes angeordnet werden kann, wobei mindestens ein erhitzter Bereich des Reaktorgefäßes im wesentlichen als ein einteiliger Quarzglaskörper ohne geschweißten Bereich hergestellt ist, und wobei mindestens ein Teil des erhitzten Bereiches durch Blasen, die fast über das gesamte Volumen verteilt sind, transluzent oder opak ist, **dadurch gekennzeichnet, dass** sich der wärmebeaufschlagte Deckenbereich (1a) im wesentlichen aus transparentem Quarzglas zusammensetzt und dass sich fast der gesamte Seitenbereich (1b) des Gefäßes (1), der sich vom wärmebeaufschlagten Deckenbereich (1a) bis zu einem Abschlussbereich am unteren Ende des Gefäßes erstreckt, aus transluzentem oder opaken Quarzglas mit darin eingeschlossenen Blasen zusammensetzt.

2. Vorrichtung zur Wärmebehandlung von Wafern nach Anspruch 1, **dadurch gekennzeichnet, dass** ein transparentes Fenster (1c) in dem Seitenbereich (1b) des Gefäßes (1) angeordnet ist, das integraler Bestandteil des übrigen Teils ist.

3. Vorrichtung zur Wärmebehandlung von Wafem nach den Ansprüchen 1 oder 2, **dadurch gekennzeichnet, dass** das Reaktorgefäß (1) auf einem Haltetisch (3) angeordnet ist, wobei ein Abschlussbereich (4) dazwischen liegt, und dass das Reaktorgefäß (1) von dem Haltetisch (3) durch Bewegung in entgegengesetzter Richtung zueinander trennbar ist, wobei ein Wafer in vorgegebener Position oberhalb des Haltetisches (3) angeordnet werden kann.

4. Vorrichtung zur Wärmebehandlung von Wafern nach Anspruch 3, **dadurch gekennzeichnet, dass** ein Gaseinlass (8) oder -einlässe und ein Gasauslass (9) oder -auslässe sich nur an der Seite des Haltetisches (3) befinden.

5. Vorrichtung zur Wärmebehandlung von Wafem nach einem oder mehreren der vorhergehenden Ansprüche, **dadurch gekennzeichnet, dass** ein oder mehrere Heizer (30) über dem Reaktorgefäß (1) im wärmebeaufschlagten Deckenbereich (1a) installiert sind, und dass der Deckenbereich (1a) des Gefäßes (1) als transparenter Bereich mit einer Durchlässigkeit von 85% oder mehr bei einer Lichtwellenlänge von 2 µm konstruiert ist, und dass fast der gesamte Seitenbereich (1b) des Gefäßes (1), abgesehen von dem erhitzten Bereich, benachbart zum Deckenbereich, der sich vom erhitzten Bereich (1d) nach unten erstreckt, ein transluzenter oder opaker Seitenbereich (1 b) ist mit einer Durchlässigkeit von 30% oder weniger bei einer Lichtwellenlänge von 2 µm.

6. Vorrichtung zur Wärmebehandlung von Wafern nach Anspruch 5, **dadurch gekennzeichnet, dass** in dem Seitenbereich (1 b) des Gefäßes (1), der abgesehen von der dem Deckenbereich des Gefäßes benachbarten Fläche verbleibt, eine Blasendichte von 20.000 Blasen/cm³ oder mehr eingestellt wird, vorzugsweise 40.000 Blasen/cm³ oder mehr, wenn die dispergierten Blasen im Bereich von 10 µm bis 250 µm gezählt werden.

## Revendications

1. Appareil pour le traitement thermique de tranches comprenant une enceinte de réacteur en forme de dôme avec une portion de plafond et une portion latérale et un chauffage ou des chauffages disposés à l'extérieur de l'enceinte de réacteur à proximité de la partie de plafond, une tranche individuelle pouvant être disposée dans l'espace intérieur de l'enceinte pour le traitement thermique par la chaleur du ou des chauffages, au moins une zone chauffée de l'enceinte de réaction étant fabriquée essentiellement comme un corps individuel en verre de quartz avec aucune partie soudée et au moins une partie de la zone chauffée étant translucide ou opaque par des bulles distribuées dans presque toute la zone, **caractérisé en ce que** la portion de plafond recevant la chaleur (1a) se compose essentiellement de verre de quartz transparent et presque toute la portion latérale (1b) de l'enceinte (1) allant de la portion de plafond (1a) recevant la chaleur à une portion de scellement à l'extrémité inférieure de l'enceinte se compose de verre de quartz opaque ou translucide avec inclusion de bulles à l'intérieur.

2. Appareil pour le traitement thermique de tranches tel que revendiqué dans la revendication 1, **caractérisé en ce qu'**une fenêtre transparente (1c) est disposée dans la partie latérale (1b) de l'enceinte (1) qui fait partie intégrante de l'autre partie.

3. Appareil pour le traitement thermique de tranches tel que revendiqué dans la revendication 1, **caractérisé en ce que** l'enceinte de réacteur (1) est placée sur une table support (3) avec une portion de scellement (4) placée entre et **en ce que** l'enceinte de réacteur (1) peut être séparée de la table support (3) de manière relative dans une direction d'éloignement, où une tranche peut être disposée à une position prédéterminée au-dessus de la table support (3).

4. Appareil pour le traitement thermique de tranches tel que revendiqué dans la revendication 3, **caractérisé en ce qu'**une entrée de gaz ou des entrées (8) et une sortie ou des sorties de gaz (9) sont logées seulement sur le côté de la table de support (3).

5. Appareil pour le traitement thermique de tranches tel que revendiqué dans une ou plusieurs des revendications précédentes, **caractérisé en ce qu'**un chauffage (30) ou des chauffages sont placés au-dessus d'une enceinte de réacteur (1) à proximité de la portion de plafond recevant la chaleur (1a) et **en ce que** la portion de plafond (1a) de l'enceinte (1) est construite comme une portion transparente ayant une transmission égale ou supérieure à 85 % d'une longueur d'onde lumineuse de 2 µm et presque toute la portion latérale (1b) de l'enceinte (1) à l'exception de la zone chauffée (1d) voisine de la portion de plafond (1a) qui est vers le bas de la zone chauffée (1d) est une portion latérale translucide ou opaque (1b) ayant une transmission supérieure ou égale à 30 % à une longueur d'onde lumineuse de 2 µm.

6. Appareil pour le traitement thermique de tranches tel que revendiqué dans la revendication 5, **caractérisé en ce qu'**une densité restante des bulles dans la partie latérale (1) de l'enceinte (1) par exclusion de la zone voisine de la portion de plafond (1a) de l'enceinte est prévue pour être inférieure ou égale à 20.0000 bulles /cm³, de préférence 40.000 bulles/cm³ si les bulles de diamètre compris entre 10 µm et 250 µm sont comptées.
